(19) Europäisches Patentamt
European Patent Office
Office européen des brevets

(11) EP 1 250 753 B1

(12) **EUROPÄISCHE PATENTSCHRIFT**

(45) Veröffentlichungstag und Bekanntmachung des Hinweises auf die Patenterteilung:
**28.07.2004 Patentblatt 2004/31**

(21) Anmeldenummer: **01905611.8**

(22) Anmeldetag: **08.01.2001**

(51) Int Cl.⁷: **H03F 1/26**

(86) Internationale Anmeldenummer:
**PCT/DE2001/000035**

(87) Internationale Veröffentlichungsnummer:
**WO 2001/052406 (19.07.2001 Gazette 2001/29)**

# (54) RAUSCHARME VERSTÄRKERSCHALTUNG UND VERFAHREN ZUR RAUSCHARMEN VERSTÄRKUNG LEISTUNGSSCHWACHER SIGNALE

LOW-NOISE AMPLIFIER CIRCUIT AND A METHOD FOR AMPLIFYING LOW-POWER SIGNALS IN A LOW-NOISE MANNER

CIRCUIT AMPLIFICATEUR A FAIBLE BRUIT ET PROCEDE PERMETTANT D'AMPLIFIER, AVEC UN FAIBLE BRUIT, DES SIGNAUX DE FAIBLE PUISSANCE

(84) Benannte Vertragsstaaten:
**DE FR GB IT**

(30) Priorität: **13.01.2000 DE 10001123**

(43) Veröffentlichungstag der Anmeldung:
**23.10.2002 Patentblatt 2002/43**

(73) Patentinhaber: **Infineon Technologies AG**
**81669 München (DE)**

(72) Erfinder: **BREDERLOW, Ralf**
**81827 München (DE)**

(74) Vertreter: **Dokter, Eric-Michael**
**Viering, Jentschura & Partner,**
**Patent- und Rechtsanwälte,**
**Postfach 22 14 43**
**80504 München (DE)**

(56) Entgegenhaltungen:
**US-A- 3 567 915**
**US-A- 3 699 461**
**US-A- 3 700 876**

EP 1 250 753 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft eine rauscharme Verstärkerschaltung und ein Verfahren zur rauscharmen Verstärkung leistungsschwacher Signale.

Bei der Signalübertragung (z.B. im Mobilfunk oder in der Raumfahrt) müssen auf der Empfängerseite häufig kleine Signale detektiert werden. Die Grenze zur Auflösung kleiner Signale wird meist durch das Rauschen der ersten Verstärkerstufe bestimmt und kann kaum beeinflusst werden.

Im Stand der Technik wurde das physikalischen Rauschen als feste Grenze betrachtet, die nur durch geschickte Wahl der Arbeitspunkte der Schaltung und der verwendeten Technologie geringfügig beeinflusst werden kann.

Ferner ist in DE 39 42 959 C2 eine Verstärkerschaltung beschrieben mit einem Eingang und einem Ausgang. Der Eingang ist auf die Eingänge von zwei parallel angeordneten Verstärkern verzweigt. Die Ausgänge von Multiplikatoren sind auf einen gemeinsamen Summationspunkt geführt, an dem das Ausgangssignal der Verstärkerschaltung vorliegt.

Aufgabe der vorliegenden Erfindung ist es, noch leistungsschwächere Signale aus dem Rauschen verstärken zu können, also die Auflösungsgrenze zu noch kleineren Signalpegeln zu verschieben.

Erfindungsgemäß wird diese Aufgabe durch eine rauscharme Verstärkerschaltung mit einem Eingang und einem Ausgang gelöst, wobei der Eingang auf die Eingange von mindestens zwei parallel angeordneten Verstärkern verzweigt, und die Ausgänge dieser Verstärker jeweils mit zwei Multiplikatoren mit zwei Eingängen verbunden sind, deren jeweils andere Eingänge jeweils mit dem Ausgang eines anderen Verstärkers verbunden sind, und die Ausgänge der Multiplikatoren auf einen gemeinsamen Summationspunkt geführt sind, an dessen Ausgang das Ausgangssignal der Verstärkerschaltung vorliegt.

Vorzugsweise kann man die Multiplikatoren dabei gleichzeitig als Frequenzmischer ausbilden. In den meisten Fällen solcher Verarbeitung ist nämlich stets auch eine Frequenzmischung zur Demodulation erforderlich.

Weiter wird die erfindungsgemäße Aufgabe durch ein Verfahren zur rauscharmen Verstärkung leistungsschwacher Signale gelöst, bei dem diese Signale den Eingängen mehrerer parallel angeordneter Verstärker zugeführt werden und die Ausgangssignale dieser Verstärker jeweils paarweise miteinander multipliziert werden und die Ergebnisse der Multiplikationen sodann summiert werden, und so das Ausgangssignal gebildet wird.

Vorzugsweise kann die Multiplikation gemeinsam mit einer Frequenzmischung erfolgen.

Es ist dabei besonders bevorzugt, wenn die Ausgangssignale der Verstärker jeweils paarweise miteinander multipliziert werden, und die Ergebnisse der Multiplikation sodann summiert werden, und so das Ausgangssignal gebildet wird.

Bei besonders ungünstigen Signal-zu-Rausch-Verhältnissen können die Signale erfindungsgemäß mehrfach übertragen werden und der Mittelwert aus den mehrfach übertragenen Signalen gebildet werden.

Eines solche Lösung war bisher aus dem Stand der Technik nicht bekannt. Die Korrelation von Signalen wurde zwar bereits in der Rauschmesstechnik ausgenutzt, um die Auflösungsgrenze von Rauschmessungen nach unten zu verschieben, wie dies beispielsweise in dem Buch von Müller "Rauschen", Springer Verlag, Berlin, 1990 in Kapitel 9 dargestellt ist. Hierbei erfolgte jedoch immer eine zeitliche Mittelung von statistischen Signalen.

Die vorliegende Erfindung wird im folgenden anhand des in den Zeichnungen dargestellten Ausführungsbeispiels näher erläutert. Es zeigen:

Figur 1 eine grundlegende Schaltungsanordnung für einen erfindungsgemäßen Verstärker;

Figur 2 eine detaillierte Darstellung der erfindungsgemäßen Verstärkerkonfiguration mit Option Frequenzmischung; und

Figur 3 eine leicht vergleichbare entsprechende Verstärkerkonfiguration gemäß dem Stand der Technik.

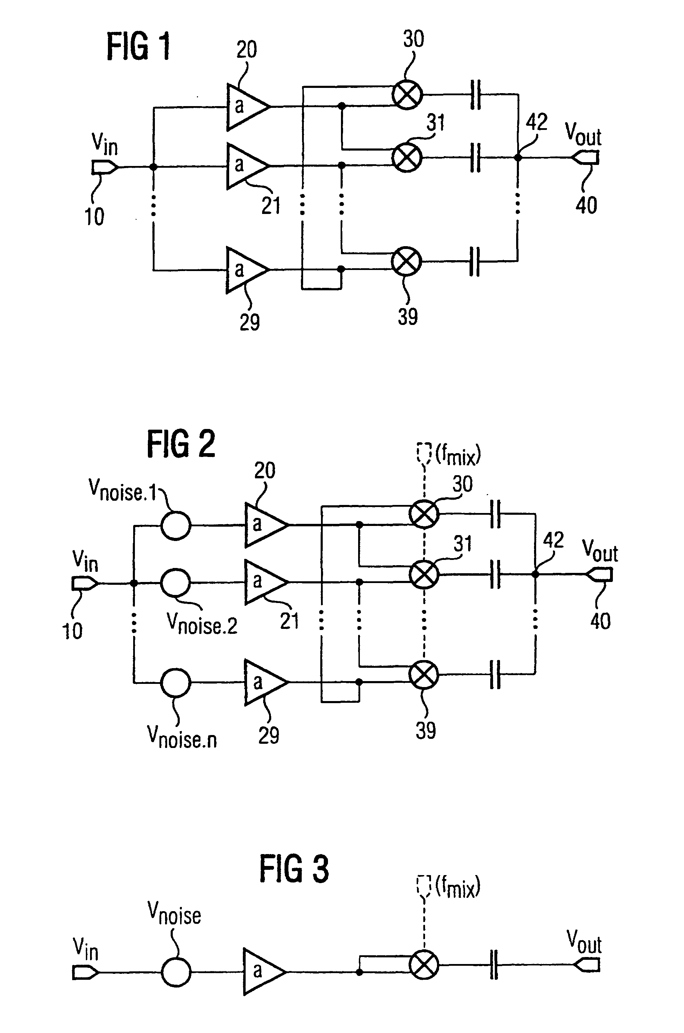

Die vorliegende Erfindung nutzt durch die Verteilung der Verstärkung auf mehrere parallele Zweige (sh. Fig. 1) einen Unterschied in der Korrelation des physikalischen Rauschens der verschiedenen Zweige und dem Nutzsignal, um so die Grenze für gerade noch auflösbare Nutzsignale nach unten zu verschieben. Im Gegensatz zum Rauschen der Verstärkereingangsstufen, das eine unkorrelierte Größe in den verschiedenen Signalpfaden ist, ist das Nutzsignal eine korrelierte Größe in allen Signalpfaden. Die Erfindung macht nun Gebrauch von der Tatsache, dass sich die Quadrate unkorrelierter Signale anders addieren als die Quadrate korrelierter Signale. Durch die der Verstärkung anschließende Multiplikation oder Quadratur, die bei Bedarf auch mit Frequenzmischung kombiniert werden kann, jeweils zweier Verstärkersignale und deren anschließende Addition werden die effektiven Amplituden der Nutzsignale mit einer günstigeren Verstärkung als das Rauschen auf den Ausgang abgebildet. Es ergibt sich so bereits bei einfacher, nicht redundanter Signalübertragung eine Verbesserung des Signal/Rausch-Verhältnisses am Ausgang der Schaltung. Dieses Verhältnis wird noch gunstiger, wenn ein bestimmtes Signal wiederholt übertragen und gemittelt werden kann.

In dieser Erfindung wird die Korrelation von parallel (und damit zeitgleich) zu verarbeiteten Signalen ausgenutzt. Durch die Multiplikation und die anschließend durchgeführte Addition der parallelen Signale beschränkt sich die Mittelung dabei ausschließlich auf die Störsignale, da sich die korrelierten Nutzsignale addieren.

Die vorgeschlagene Architektur eröffnet zudem die Möglichkeit, die Rauschunterdrückung mit der in vielen Fällen notwendigen Frequenzmischung zu verknüpfen. Der Ort, an dem die Bildung der Summen (zur Ausnutzung der unterschiedlichen Korrelation der Signale und des Rauschens) erfolgt, ist beliebig und kann abweichend von Fig. 1 beispielsweise auch erst im signalverarbeitenden digitalen Teil eines Systems oder nach einer weiteren Mischung erfolgen.

Wie in den Figuren 1 und 2 dargestellt, umfasst eine erfindungsgemäße Verstärkerschaltung einen Eingang 10, an dem das Eingangssignal $V_{in}$ ankommt. Erfindungsgemäß wird dieses Eingangssignal auf mehrere Verstärker 20 ... 29 verteilt, deren Ausgangssignale jeweils einem Multiplikator 30 ... 39 zugeführt werden. Jeder dieser Multiplikatoren 30 ... 39 verfügt über zwei Eingänge, der jeweils andere Eingang ist mit dem benachbarten Verstärker (29, 20 ... 28) verbunden. Die Ausgänge der Multiplikatoren 30 ... 39 sind mit einem Summationspunkt 42 verbunden, in dem die entsprechenden Ausgangssignale aufsummiert werden. Der Ausgang dieses Summationspunktes bildet gleichzeitig den Ausgang 40 der erfindungsgemäßen Verstärkerschaltung, an dem das Ausgangssignal $V_{out}$ anliegt.

Die Multiplikatoren 30 ... 39 können zusätzlich gleichzeitig als Frequenzmischer verwendet werden, wie dies in Figur 2 dargestellt ist. Hier wird jedem der Multiplikatoren noch die Mischfrequenz $f_{mix}$ fakultativ zugeführt.

Figur 3 zeigt eine vergleichbare Verstärkerschaltung nach dem Stand der Technik.

Die Verfahrensweise der Erfindung wird im folgenden im einzelnen im Zusammenhang mit den mathematisch-theoretischen Grundlagen erläutert:

Bei Verwendung mehrerer Verstärker, die ein und dasselbe Nutzsignal verstärken, ist das zusätzliche Rauschen dieser verschiedenen Verstärker (im Gegensatz zum Nutzsignal) nicht korreliert.

Durch eine Multiplikation verschiedener verstärkter Nutzsignale erhält man korrelierte Quadrate der verstärkten Nutzsignale und unkorrelierte Quadrate der Rauschsignale der einzelnen Verstärker.

Addiert man diese Quadrate, so ergeben sich aufgrund der unterschiedlichen Eigenschaften andere Summenquadrate für unkorrelierte und korrelierte Rauschsignale:

$$\sum_{i=1}^{n} v_{noise,i} \cdot v_{noise,i} = n \cdot v_{noise,mean}^2 \qquad (1.a)$$

Dabei ist $v_{noise,i}$ das Rauschen der Verstärker. Das Produkt des Rauschens eines Verstärkers mit sich selbst ist ein korreliertes Signal. $v_{noise,mean}$ ist die mittlere Rauschamplitude eines einzelnen Verstärkers. Die Produkte der Rauschsignale der unterschiedlichen Verstärker in Fig. 1 sind unkorreliert und die Größe der Multiplikation dieser Signale ist deswegen kleiner als das korrelierte Produkt eines Rauschsignals mit sich selbst.

$$\sum_{i=1}^{n} v_{noise,i} \cdot v_{noise,i+1} \approx \sqrt{n} \cdot v_{noise,mean}^2 < n \cdot v_{noise,mean}^2 \qquad (1.b)$$

Die Abhängigkeit der unkorrelierten Produkte von der Wurzel der Zahl der beteiligten Verstärker n in (1.b) ist eine Abschätzung. Das Produkt der beiden Größen aus Gleichung (la) und (1b) heißt Korrelationskoeffizient r:

$$r = \frac{\sum_{i=1}^{n} v_{noise,i} \cdot v_{noise,i+1}}{\sqrt{\sum_{i=1}^{n} v_{noise,i}^2 \cdot \sum_{j=1}^{n} v_{noise,j}^2}} \approx \frac{1}{\sqrt{n}} \qquad (2)$$

Nach I.N. Bronstein, K.A. Semendjajew, "Taschenbuch der Mathematik", Verlag Harry Deutsch, Thun 1989, S. 603 ergibt sich für große n bei unkorrelierten Größen für r der Wert 0. Das Produkt vollständig unkorrelierter Größen verschwindet somit bei großen n.

Die Eingangsimpedanz eines Verstärkers bestimmt das Rauschverhalten des Verstärkers in ähnlicher Weise wie das thermische Rauschen das Rauschverhalten eines Widerstandes bestimmt. Sie ist durch folgende Gleichung

gegeben (sh. H. Ott "noise reduction techniques in electronic systems", Kapitel 9, J. Wiley & Sons, NY, 1988):

$$\overline{v^2_{noise}} \sim R_{source} \qquad oder \qquad i^2_{noise} \sim 1/R_{source} \qquad (3)$$

$v_{noise}$ ist hier das Spannungsrauschen, $i_{noise}$ das Stromrauschen des Verstärkers.

Gute rauscharme Verstärker rauschen gemäß der oben beschriebenen Gesetzmäßigkeit für das Eigenrauschen, sofern sie in günstigen Arbeitspunkten betrieben werden. Da in den meisten Systemen die Eingangsimpedanz vorgegeben ist, ist auch die Dimensionierung des Verstärkers bzw. die Zahl der parallelgeschalteten (Einheits)-Verstärker vorgegeben. Damit führt die Realisierung einer Schaltung gem. Fig. 1 im (relativ) hochimpedanten MOS-System zu keinem unnötigen Flächenverbrauch. Der im folgenden durchgeführte Vergleich ist jedoch praktisch unabhängig von Art und Aufbau des Verstärkers, solange dieser gute Rauscheigenschaften hat.

Berechnet man das resultierende Signal am Ausgang in Fig. 2 und 3, so ergeben sich durch die Ausnutzung des parallelen Korrelationsprinzips (Fig. 2) bessere Rauscheigenschaften gegenüber dem konventionellen Ansatz:

$$\Delta v^2_{in,noise} = \frac{v^2_{out,Fig.3} - v^2_{out,Fig.\ 2}}{a^2 \cdot n} = (1 - r) \cdot v^2_{noise,mean} \qquad (4)$$

Dabei ist $v_{in,noise}$ das auf den Eingang bezogene Rauschsignal. Für die einzelnen Verstärker wurden gleiche elektrische Eigenschaften angenommen. a ist die Verstärkung der einzelnen Verstärker, $a^2n$ die des Gesamtsystems. Da die Eingangsimpedanz des Gesamtsystems meist vorgegeben ist, ergibt sich Gleichung (4) oder Gleichung (3) unabhängig von der Wahl der Verstärkerkonfiguration (z.B. $n$ Verstärker mit Verstärkung $a$ oder ein Verstärker mit Verstärkung $a\sqrt{n}$), solange die Gesamtverstärkung gleich gewählt ist und alle Verstärker ideale Rauscheigenschaften haben.

Die Verbesserung der Rauscheigenschaften in Fig. 2 gegenüber Fig. 3 steigt mit der Zahl $n$ der parallelgeschalteten Verstärker an, da $r$ in diesem Fall im Mittel kleiner wird. Dabei lässt sich in etwa eine Verbesserung proportional zur Wurzel der beteiligten Einzelverstärker erzielen. In gleicher Weise geht auch eine Mittelung mehrmalig übertragener Signale in die Verbesserung der Rauscheigenschaften ein.

## Patentansprüche

1. Rauscharme Verstärkerschaltung mit einem Eingang (10) und einem Ausgang (40), bei der der Eingang auf die Eingänge von mindestens zwei parallel angeordneten Verstärkern (20 ... 29) verzweigt, und die Ausgänge dieser Verstärker jeweils mit zwei Multiplikatoren (30 ... 39) verbunden sind, deren jeweils andere Eingänge jeweils mit dem Ausgang eines anderen Verstärkers (29, 20 ... 28) verbunden sind, und die Ausgänge der Multiplikatoren (30 ... 39) auf einem gemeinsamen Summationspunkt (42) geführt sind, an dessen Ausgang (40) das Ausgangssignal der Verstärkerschaltung vorliegt.

2. Verstärkerschaltung nach Anspruch 1, bei der die Multiplikatoren (30 ... 39) gleichzeitig als Frequenzmischer ausgebildet sind.

3. Verfahren zur rauscharmen Verstärkung leistungsschwacher Signale, bei dem diese Signale den Eingängen mehrerer parallel angeordneter Verstärker (20 ... 29) zugeführt werden und bei dem die Ausgangssignale der Verstärker (20 ... 29) jeweils paarweise miteinander multipliziert werden und die Ergebnisse der Multiplikationen sodann summiert werden, und so das Ausgangssignal gebildet wird.

4. Verfahren nach Anspruch 3, bei dem die Multiplikation gemeinsam mit einer Frequenzmischung erfolgt.

5. Verfahren nach Anspruch 3 oder 4, bei dem die Signale mehrmals übertragen werden und der Mittelwert aus den mehrmals übertragenen Signalen gebildet wird.

## Claims

1. A low-noise amplifier circuit having an input (10) and an output (40), in the case of which the input is branched onto the inputs of at least two amplifiers (20 ... 29) arranged in parallel, and the outputs of these amplifiers are respectively connected to two multipliers (30 ... 39) whose respective other inputs are respectively connected to the output of another amplifier (29, 20 ... 28), and the outputs of the multipliers (30 ... 39) are led to a common summing point (42) at whose output (40) the output signal of the amplifier circuit is present.

2. The amplifier circuit as claimed in claim 1, in which the multipliers (30 ... 39) are designed simultaneously as frequency mixers.

3. A method for low-noise amplification of low-power signals, in which these signals are fed to the inputs of a plurality of amplifiers (20 ... 29) arranged in parallel, and in which the output signals of the amplifiers (20 ... 29) are respectively multiplied by one another in pairs, and the results of the multiplications are then summed and the output signal is thus formed.

4. The method as claimed in claim 3, in which the multiplication is performed jointly with frequency mixing.

5. The method as claimed in claim 3 or 4, in which the signals are transmitted repeatedly and the mean value is formed from the repeatedly transmitted signals.

## Revendications

1. Circuit amplificateur à faible bruit comportant une entrée (10) et une sortie (40) et dans lequel l'entrée est ramifiée entre les entrées d'au moins' deux amplificateurs (20 ... 29) disposés en parallèle, et les sorties de ces amplificateurs sont reliées respectivement à deux multiplieurs (30 ... 39), dont les autres entrées respectives sont reliées respectivement à la sortie d'un autre amplificateur (29, 20 ... 28), et les sorties des multiplieurs (30 ... 39) sont raccordées à un point de sommation commun (42), sur la sortie (40) duquel est présent le signal de sortie du circuit amplificateur.

2. Circuit amplificateur selon la revendication 1, dans lequel les multiplieurs (30 ... 39) sont agencés simultanément en tant que mélangeurs de fréquences.

3. Procédé pour l'amplification à faible bruit de signaux de faible puissance, selon lequel ces signaux sont envoyés aux entrées de plusieurs amplificateurs (20 ... 29) disposés en parallèle et selon lequel les signaux de sortie des amplificateurs (20 ... 29) sont multipliés respectivement par couples entre eux et les résultats des multiplications sont alors sommées et le signal de sortie est ainsi formé.

4. Procédé selon la revendication 3, selon lequel la multiplication s'effectue en commun avec un mélange de fréquences.

5. Procédé selon la revendication 3 ou 4, selon lequel les signaux sont transmis plusieurs fois et la valeur moyenne est formée à partir des signaux transmis plusieurs fois.

FIG 1

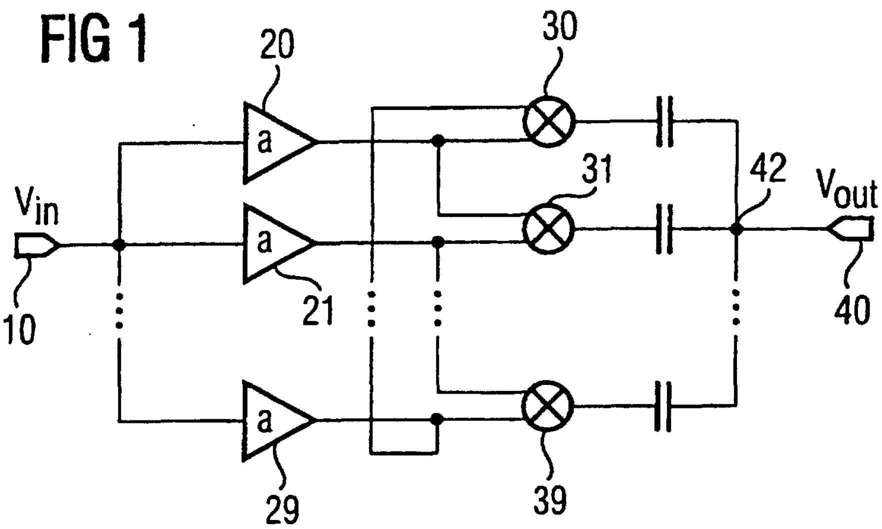


FIG 2

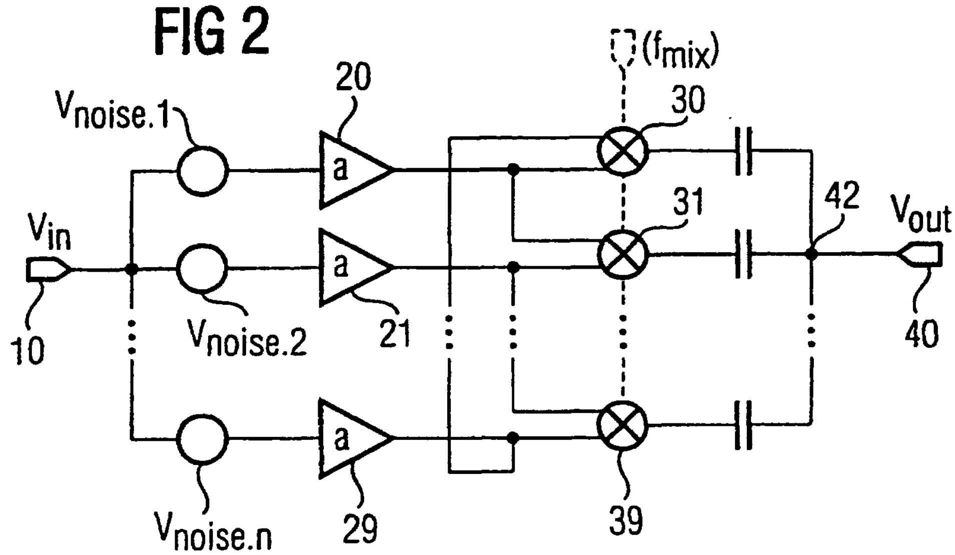


FIG 3